# EUROPEAN PATENT APPLICATION

(11) **EP 4 668 011 A1**
(43) Date of publication of application: **24.12.2025**
(21) Application number: 24773745.5
(22) Date of filing: 02.01.2024
(51) Int. Cl.: G02F 1/39

(54) **OPTICAL MODULATION AND AMPLIFICATION CHIP, LIGHT SOURCE CHIP, OPTICAL MODULE, AND RELATED METHOD**

(30) Priority: 17.03.2023 CN 202310293492
(71) Applicant: Huawei Technologies Co., Ltd., Shenzhen, Guangdong 518129 (CN)
(72) Inventor: WU, Jiliang, Shenzhen, Guangdong 518129 (CN); CHENG, Yuanbing, Shenzhen, Guangdong 518129 (CN); LI, Yanbo, Shenzhen, Guangdong 518129 (CN)
(74) Representative: Isarpatent
(86) International application number: PCT/CN2024/070055
(87) International publication number: WO 2024/193175

(57) **Abstract**

An optical modulation and amplification chip, a light source chip (1002), an optical module, and an optical modulation and amplification method are disclosed, which simultaneously satisfy the needs for achieving high gain amplification, rapid modulation, and high output power for input light. The optical modulation and amplification chip includes a first region and a second region, where one region is for amplifying light, and the other region is for amplifying and modulating the light. The first region and the second region share a same substrate (10), and are electrically isolated. The first region is close to a light input end of the optical modulation and amplification chip, and the second region is close to a light output end of the optical modulation and amplification chip. A first waveguide (401) of the first region and a second waveguide (402) of the second region are connected in series along a light transmission direction of the optical modulation and amplification chip. An optical confinement factor of a first active layer (301) of the first region is greater than an optical confinement factor of a second active layer (302) of the second region.

## Description

This application claims priority to Chinese Patent Application No. 202310293492.7, filed with the China National Intellectual Property Administration on March 17, 2023 and entitled "OPTICAL MODULATION AND AMPLIFICATION CHIP, LIGHT SOURCE CHIP, OPTICAL MODULE, AND RELATED METHOD", which is incorporated herein by reference in its entirety.

### TECHNICAL FIELD

This application relates to the field of optical communication, and in particular, to an optical modulation and amplification chip, a light source chip, an optical module, and a related method.

### BACKGROUND

An optical time domain reflectometer (Optical Time Domain Reflectometer, OTDR) and a coherent optical time domain reflectometer (Coherent OTDR, C-OTDR) diagnose optical fiber faults by detecting reflected light. For example, by emitting optical pulses to an optical fiber under test, a photoelectric detector detects intensity of Rayleigh scattered light and intensity of Fresnel reflected light returned from the optical fiber, to obtain physical characteristics such as length and attenuation of the optical fiber under test, and accurately positions event points and fault spots along an optical path by using a data analysis function.

In a conventional technology, continuous light emitted by a laser is modulated and amplified by using a semiconductor optical amplifier (Semiconductor Optical Amplifier, SOA) to obtain an optical pulse. However, due to limitations such as low saturated optical power and significant electrical parasitic parameters of the SOA, it is challengeable to achieve both higher output optical power and faster modulation speeds simultaneously with substantial gain.

### SUMMARY

Embodiments of this application provide an optical modulation and amplification chip, a light source chip, an optical module, and a related method, which can simultaneously satisfy the needs for achieving high gain amplification, rapid modulation, and high output power for input light.

According to a first aspect, an embodiment of this application provides an optical modulation and amplification chip. The optical modulation and amplification chip includes a first region and a second region. The first region and the second region share a same substrate, and the first region and the second region are electrically isolated. The first region is close to a light input end of the optical modulation and amplification chip, and the second region is close to a light output end of the optical modulation and amplification chip. A first waveguide of the first region and a second waveguide of the second region are connected in series along a light transmission direction of the optical modulation and amplification chip. An optical confinement factor of a first active layer of the first region is greater than an optical confinement factor of a second active layer of the second region. Specifically, the first region is for amplifying light transmitted in the first waveguide, and the second region is for amplifying and modulating the light transmitted in the second waveguide to obtain pulsed light. Alternatively, the first region is for amplifying and modulating light transmitted in the first waveguide to obtain pulsed light, and the second region is for amplifying the pulsed light transmitted in the second waveguide.

In this implementation, the optical confinement factor of the first active layer of the first region is large, to facilitate implementation of a high gain. The optical confinement factor of the second active layer of the second region is small, and the second region has a high saturated output optical power, to facilitate implementation of a high output power. Therefore, the optical modulation and amplification chip provided in this application can meet requirements for the high gain amplification and the high output power. It should be understood that, in a region in which light is modulated, the light is absorbed in the region under driving of a modulation signal with an amplitude of 0, and the light is amplified in the region under driving of a modulation signal with an amplitude of 1, so that an extinction ratio and an optical power of pulsed light are increased. In addition, in a scenario in which light is amplified in the first region and the light is amplified and modulated in the second region, the light is amplified in the first region, so that the light transmitted in the second region has a high gain. Therefore, only a small gain needs to be implemented in the second region, and a parasitic parameter is reduced, so that a rate of modulating the light in the second region is increased, and an optical pulse with a narrow pulse width is generated.

In some possible implementations, the first region and the second region share a same active layer. The first waveguide includes a first epitaxial layer, and the second waveguide includes a second epitaxial layer. A refractive index of the first epitaxial layer is greater than a refractive index of the second epitaxial layer. Therefore, the first epitaxial layer may increase a light field of the first region, and increase the optical confinement factor of the first active layer, so that the optical confinement factor of the first active layer is greater than the optical confinement factor of the second active layer. It should be understood that, the first region and the second region share the same active layer. Therefore, in the implementations, a manufacturing process is simplified.

In some possible implementations, a first passive waveguide layer of the first region and a second passive waveguide layer of the second region are located on the substrate, the first active layer is located on the first passive waveguide layer, and the second active layer is located on the second passive waveguide layer. A thickness of the first passive waveguide layer is less than a thickness of the second passive waveguide layer, and/or a refractive index of the first passive waveguide layer is less than a refractive index of the second passive waveguide layer, and/or a distance between the first passive waveguide layer and the first active layer is less than a distance between the second passive waveguide layer and the second active layer. It should be understood that, in such a manner, the second passive waveguide layer may reduce a light field of the second region, and reduce the optical confinement factor of the second active layer, so that the optical confinement factor of the first active layer is greater than the optical confinement factor of the second active layer. In addition, in the implementations, the first region and the second region may also share the same active layer, to facilitate simplification of the manufacturing process.

In some possible implementations, the first region and/or the second region includes an optical filtering structure. The optical filtering structure is configured to perform bandpass filtering on amplified spontaneous emission (Amplified Spontaneous Emission, ASE) light generated through amplification and modulation in the optical modulation and amplification chip, to filter out the ASE light. The ASE light is not required in practice, and the ASE light has a large spectral width, making it difficult to absorb the ASE light. Therefore, the ASE light is filtered out, so that the extinction ratio of the pulsed light can be further increased.

In some possible implementations, the optical filtering structure is a chirped grating, and an included angle between the chirped grating and the light transmission direction of the optical modulation and amplification chip is greater than 0° and less than 90°. In other words, the chirped grating is neither parallel nor perpendicular to the light transmission direction. In such a design manner, a resonant cavity may be prevented from being formed between reflected light and an end surface of the optical modulation and amplification chip, to avoid impact on an optical gain.

In some possible implementations, the optical filtering structure is a multimode interference (Multimode Interference, MMI) waveguide, and the MMI waveguide is connected in series with the first waveguide or the second waveguide. In a filtering manner of the MMI waveguide, only a wide waveguide needs to be etched, so that manufacturing is simple.

In some possible implementations, a first electrode of the first region is configured to load a direct current, and a second electrode of the second region is configured to load a modulation signal. Alternatively, a first electrode of the first region is configured to load a modulation signal, and a second electrode of the second region is configured to load a direct current.

In some possible implementations, the first waveguide uses a ridge waveguide structure or a buried heterojunction (Buried Heterogeneous, BH) structure, and the second waveguide uses a ridge waveguide structure or a BH structure, so that an application scenario of this solution is expanded.

In some possible implementations, a groove is provided for electrical isolation between the first electrode of the first region and the second electrode of the second region.

In some possible implementations, there are protons or inert ions injected into the groove, to improve an electrical isolation effect.

In some possible implementations, there are protons or inert ions injected between the first electrode of the first region and the second electrode of the second region, so that flexibility of this solution is improved.

According to a second aspect, an embodiment of this application provides a light source chip. The light source chip includes a laser and the optical modulation and amplification chip described in any one of the implementations in the first aspect. The laser and the optical modulation and amplification chip are integrated on a same substrate. The optical modulation and amplification chip is configured to modulate and amplify light emitted by the laser.

According to a third aspect, an embodiment of this application provides an optical module. The optical module includes a laser, a driver, and the optical modulation and amplification chip described in any one of the implementations in the first aspect. The driver is configured to drive the laser to emit light, and drive the optical modulation and amplification chip to modulate and amplify the light emitted by the laser.

According to a fourth aspect, an embodiment of this application provides an optical module. The optical module includes a driver and the light source chip described in the second aspect. The driver is configured to drive a laser in the light source chip to emit light, and drive an optical modulation and amplification chip in the light source chip to modulate and amplify the light emitted by the laser.

According to a fifth aspect, an embodiment of this application provides an optical modulation and amplification method. The method includes the following steps. First, input light of an optical modulation and amplification chip is obtained. The optical modulation and amplification chip includes a first region and a second region, and the first region and the second region are electrically isolated. The first region is close to a light input end of the optical modulation and amplification chip, and the second region is close to a light output end of the optical modulation and amplification chip. The input light is transmitted in a first waveguide of the first region and a second waveguide of the second region. An optical confinement factor of a first active layer of the first region is greater than an optical confinement factor of a second active layer of the second region. Then, the light transmitted in the first waveguide is amplified, and the light transmitted in the second waveguide is amplified and modulated to obtain pulsed light. Alternatively, the light transmitted in the first waveguide is amplified and modulated to obtain pulsed light, and the pulsed light transmitted in the second waveguide is amplified. Then, the pulsed light is output, where an extinction ratio of the pulsed light exceeds 40 dB.

In some possible implementations, the method further includes: performing bandpass filtering on ASE light generated through amplification and modulation in the optical modulation and amplification chip, to filter out the ASE light. An extinction ratio of pulsed light post-bandpass filtering exceeds 50 dB.

In some possible implementations, amplifying the light transmitted in the first waveguide, and amplifying and modulating the light transmitted in the second waveguide to obtain the pulsed light includes: loading a direct current by using a first electrode of the first region to amplify the light transmitted in the first waveguide, and loading a modulation signal by using a second electrode of the second region to amplify and modulate the light transmitted in the second waveguide to obtain the pulsed light. Amplifying and modulating the light transmitted in the first waveguide to obtain the pulsed light, and amplifying the pulsed light transmitted in the second waveguide includes: loading a modulation signal by using a first electrode of the first region to amplify and modulate the light transmitted in the first waveguide to obtain the pulsed light, and loading a direct current by using a second electrode of the second region to amplify the pulsed light transmitted in the second waveguide.

The optical modulation and amplification chip provided in this embodiment of this application can meet requirements for high gain amplification and a high output power. It should be understood that, in a region in which light is modulated, the light is absorbed in the region under driving of a modulation signal with an amplitude of 0, and the light is amplified in the region under driving of a modulation signal with an amplitude of 1, so that an extinction ratio and an optical power of pulsed light are increased. In addition, in a scenario in which light is amplified in a first region and the light is amplified and modulated in a second region, the light is amplified in the first region, so that the light transmitted in the second region has a high gain. Therefore, only a small gain needs to be implemented in the second region, and a parasitic parameter is reduced, so that a rate of modulating the light in the second region is increased, and an optical pulse with a narrow pulse width is generated.

### BRIEF DESCRIPTION OF DRAWINGS

FIG. 1 is a diagram of a first implementation of an optical modulation and amplification chip according to an embodiment of this application;
FIG. 2 is a diagram of a second implementation of an optical modulation and amplification chip according to an embodiment of this application;
FIG. 3 is a first main view of an optical modulation and amplification chip according to an embodiment of this application;
FIG. 4 is a second main view of an optical modulation and amplification chip according to an embodiment of this application;
FIG. 5 is a diagram of a filtering spectrum of an optical filtering structure according to an embodiment of this application;
FIG. 6 is a diagram of a first implementation of an optical filtering structure according to an embodiment of this application;
FIG. 7 is a diagram of a second implementation of an optical filtering structure according to an embodiment of this application;
FIG. 8 is a diagram of a structure of a light source chip according to an embodiment of this application;
FIG. 9 is a diagram of a structure of an optical module according to an embodiment of this application;
FIG. 10 is a diagram of a structure of an optical module according to an embodiment of this application; and
FIG. 11 is a diagram of an optical modulation and amplification method according to an embodiment of this application.

### DESCRIPTION OF EMBODIMENTS

Embodiments of this application provide an optical modulation and amplification chip, a light source chip, an optical module, and a related method, which can meet requirements for implementing high gain amplification, fast modulation, and a high output power for input light.

It should be noted that, terms "first", "second", and the like in the specification, claims, and accompanying drawings of this application are intended to distinguish between similar objects, but do not limit a specific order or sequence. It should be understood that, the foregoing terms may be interchanged in proper cases, so that embodiments described in this application can be implemented in an order other than the content described in this application. Further, a term "include", and any variations thereof, are intended to cover non-exclusive inclusions. For example, a process, method, system, product, or device that includes a list of steps or units is not necessarily limited to those expressly enumerated steps or units, but may include other steps or units not expressly enumerated or inherent to such a process, method, product, or device.

It should be understood that, an optical modulation and amplification chip provided in embodiments of this application may modulate and amplify light, and may be specifically used in different scenarios such as an optical time domain reflectometer (Optical Time Domain Reflectometer, OTDR), a coherent optical time domain reflectometer (Coherent Optical Time Domain Reflectometer, C-OTDR), an optical cross-connect (Optical Cross-Connect, OXC), or a digitalized quick optical distribution network (Digital and Quick Optical Distributed Network, DQ-ODN). The following describes in detail the optical modulation and amplification chip provided in embodiments of this application.

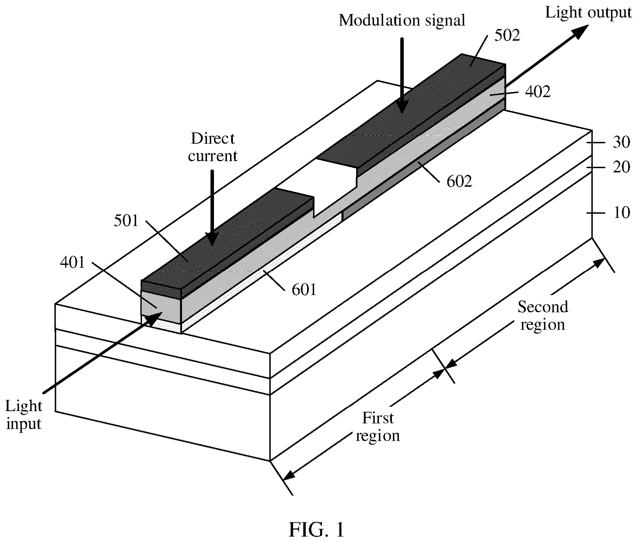

FIG. 1 is a diagram of a first implementation of an optical modulation and amplification chip according to an embodiment of this application. As shown in FIG. 1, the optical modulation and amplification chip includes a first region and a second region, and the first region and the second region are electrically isolated. The first region is close to a light input end of the optical modulation and amplification chip, and the second region is close to a light output end of the optical modulation and amplification chip. For example, a first electrode 501 of the first region and a second electrode 502 of the second region are electrically isolated, and the optical modulation and amplification chip may be divided into the first region and the second region by using a location at which the first electrode 501 and the second electrode 502 are electrically isolated as a boundary. The first region and the second region share a same substrate 10, and a passive waveguide layer 20 and an active layer 30 are further successively arranged on the substrate 10. The first region and the second region may share a same active layer or use different active layers, and the first region and the second region may share a same passive waveguide layer or use different passive waveguide layers. The following separately provides descriptions with reference to specific embodiments.

A waveguide layer is above the active layer 30, where a first waveguide 401 of the first region and a second waveguide 402 of the second region are connected in series along a light transmission direction. In other words, light input to the optical modulation and amplification chip is output after passing through the first waveguide 401 and the second waveguide 402 in sequence. It should be understood that, the light input to the optical modulation and amplification chip is light that is not modulated, and may also be referred to as an optical carrier or direct current light. It should be noted that, the waveguide layer may use a ridge waveguide structure shown in FIG. 1, or use another structure like a buried heterojunction (Buried Heterogeneous, BH). This is not limited herein. An electrical contact layer is above the waveguide layer. The electrical contact layer specifically includes P-type electrodes, where a P-type electrode located in the first region and a P-type electrode located in the second region are electrically isolated. An N-type electrode is further arranged below the substrate 10, and the first region and the second region share the N-type electrode. For ease of description, electrodes acting on the first region and the second region are respectively referred to as the first electrode 501 and the second electrode 502 below. The first electrode 501 includes the N-type electrode and the P-type electrode located in the first region, and the second electrode 502 includes the N-type electrode and the P-type electrode located in the second region. The first electrode 501 and the second electrode 502 may be driven in different manners to implement different functions on light. For example, the light may be modulated and amplified, or the light may be amplified only.

In a possible implementation, as shown in FIG. 1, the first electrode 501 is configured to load a direct current, to amplify light transmitted in the first waveguide 401. The second electrode 502 is configured to load a modulation signal, to amplify and modulate the light transmitted in the second waveguide 402 to obtain pulsed light.

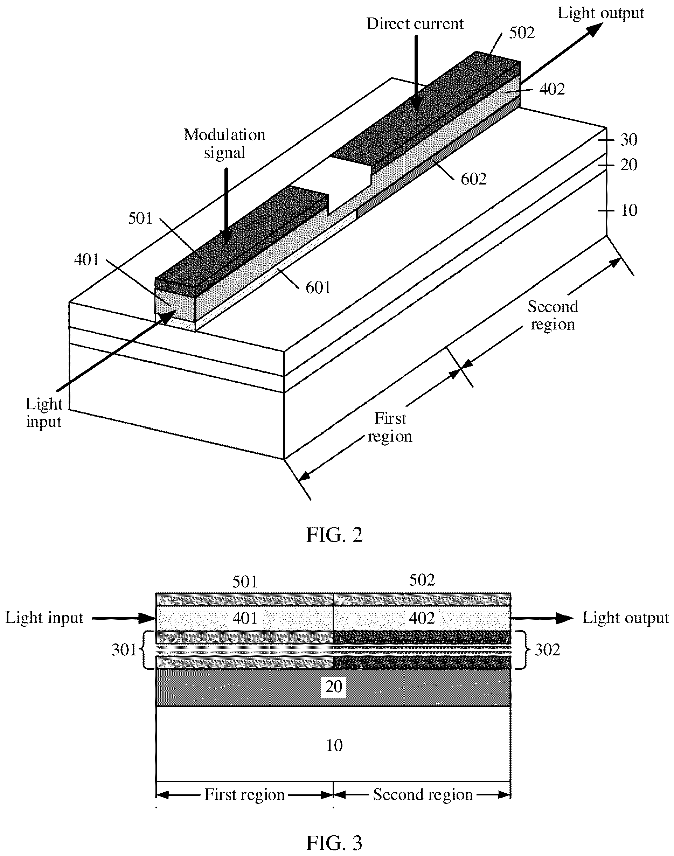

FIG. 2 is a diagram of a second implementation of an optical modulation and amplification chip according to an embodiment of this application. As shown in FIG. 2, in another possible implementation, the first electrode 501 is configured to load a modulation signal, to amplify and modulate light transmitted in the first waveguide 401 to obtain pulsed light. The second electrode 502 is configured to load a direct current, to amplify the pulsed light transmitted in the second waveguide 402.

With reference to the implementations shown in FIG. 1 and FIG. 2, in a region in which a modulation signal is loaded, light is modulated and amplified. Specifically, for light passing through the region, the light is absorbed in the region under driving of a modulation signal with an amplitude of 0, and the light is amplified in the region under driving of a modulation signal with an amplitude of 1, so that an extinction ratio and an optical power of pulsed light are increased. For example, the extinction ratio of the pulsed light may exceed 40 dB, and the optical power may also be increased. This is different from conventional intensity light modulation. A conventional light modulator generates an optical signal mainly based on a coherent cancellation function or an electro-absorption principle of light, and is unable to amplify an optical power while producing the optical signal. It should be noted herein that, the modulation signal with the amplitude of 1 and the modulation signal with the amplitude of 0 are relative concepts, which are not specific values. For example, the modulation signal with the amplitude of 0 may be less than a transparent current of the region, or may be a reverse bias voltage. The transparent current herein is defined as a current value when a density of carriers injected into the region is less than a density of transparent carriers in the region.

It should be noted that, in the optical modulation and amplification chip provided in this application, a part that is of the active layer 30 and that is located in the first region is referred to as a first active layer, and a part that is of the active layer 30 and that is located in the second region is referred to as a second active layer. An optical confinement factor of the first active layer is greater than an optical confinement factor of the second active layer. Therefore, a high gain can be implemented in the first region in a short device length, and the second region has a high saturated output optical power, to facilitate implementation of a high output power. In this way, the optical modulation and amplification chip can meet requirements for implementing the high gain amplification and the high output power for input light. It should be understood that, in the implementation shown in FIG. 1, light is amplified in the first region, so that the light transmitted in the second region has a high gain, and only a small gain needs to be implemented in the second region. In comparison with a single-electrode chip, the second region is only a part of the optical modulation and amplification chip, so that a parasitic parameter is reduced, to facilitate increasing of a rate of modulating the light in the second region, and generation of an optical pulse with a narrow pulse width. The following describes several specific implementations that meet the foregoing optical confinement factor requirement.

Implementation 1: The first region and the second region share the same active layer, and the first region and the second region use different epitaxial layers.

As shown in FIG. 1 or FIG. 2, the first region and the second region share the same active layer 30, a first epitaxial layer 601 is arranged in the first region, and a second epitaxial layer 602 is arranged in the second region. For example, the first epitaxial layer 601 may be arranged in the first waveguide 401, and the second epitaxial layer 602 may be arranged in the second waveguide 402. A refractive index of the first epitaxial layer 601 is greater than a refractive index of the second epitaxial layer 602. Therefore, the first epitaxial layer 601 may increase a light field distribution proportion of the first active layer, and increase the optical confinement factor of the first active layer, so that the optical confinement factor of the first active layer is greater than the optical confinement factor of the second active layer. In an example, the first waveguide 401, the second waveguide 402, and the second epitaxial layer 602 are made of an InP material, and the first epitaxial layer 601 is made of an InGaAsP material with a high refractive index. It should be understood that, the first region and the second region share the same active layer 30. Therefore, in Implementation 1, a chip manufacturing process is simplified, and a maximum output optical power that can be implemented is large.

Implementation 2: The first region and the second region use different active layers.

FIG. 3 is a first main view of an optical modulation and amplification chip according to an embodiment of this application. As shown in FIG. 3, the first region uses a first active layer 301, and the second region uses a second active layer 302. In Implementation 2, active layers with different specifications are arranged, so that the optical confinement factor of the first active layer is greater than the optical confinement factor of the second active layer. It should be understood that, compared with Implementation 1, in Implementation 2, no epitaxial layer needs to be arranged above the active layer, but a chip manufacturing process is more complex, and a maximum output optical power that can be implemented is small.

Implementation 3: The first region and the second region use different passive waveguide layers.

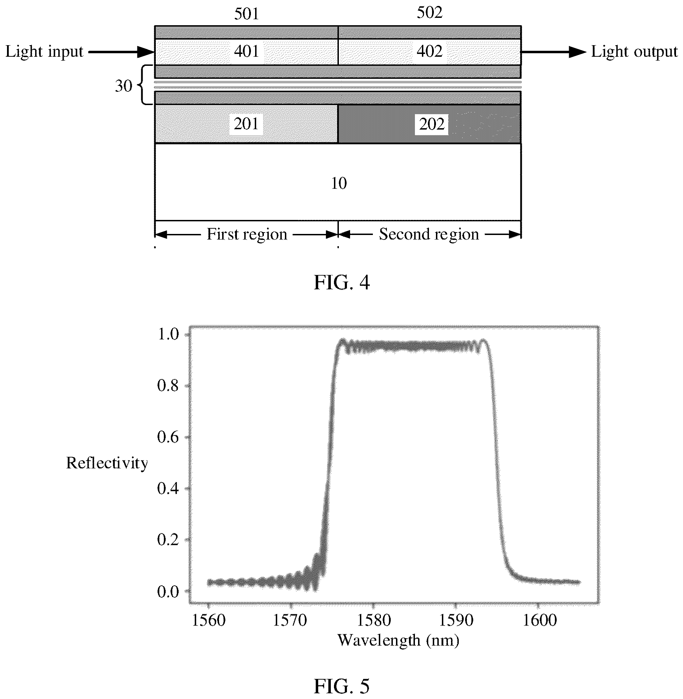

FIG. 4 is a second main view of an optical modulation and amplification chip according to an embodiment of this application. As shown in FIG. 4, the first region uses a first passive waveguide layer 201, and the second region uses a second passive waveguide layer 202. The first passive waveguide layer 201 and the second passive waveguide layer 202 meet at least one of the following three conditions, so that the second passive waveguide layer 202 reduces a light field distribution proportion of the second active layer, and reduces the optical confinement factor of the second active layer, so that the optical confinement factor of the first active layer is greater than the optical confinement factor of the second active layer. Condition 1: A thickness of the first passive waveguide layer 201 is less than a thickness of the second passive waveguide layer 202. Condition 2: A refractive index of the first passive waveguide layer 201 is less than a refractive index of the second passive waveguide layer 202. Condition 3: A distance between the first passive waveguide layer 201 and the first active layer is less than a distance between the second passive waveguide layer 202 and the second active layer.

It should be noted that, through some combinations or transformations based on the foregoing three implementations, there may also be other implementations. No accompanying drawings are provided herein one by one for presentation. For example, Implementation 1 may be combined with Implementation 3. For another example, Implementation 2 may be combined with Implementation 3. For still another example, based on Implementation 3, the first region and the second region share the same active layer, but no epitaxial layer is arranged. For yet another example, based on Implementation 1, the first region and the second region may share the same passive waveguide layer.

It should be further noted that, the active layer described above further includes a lower separate confinement layer, a multiquantum well, and an upper separate confinement layer from bottom to top in sequence. The lower separate confinement layer and the upper separate confinement layer are configured to confine carriers and photons in a vertical direction. The multiquantum well is configured to convert electric energy into photons. It should be understood that, a specific thickness and a material of each layer in the optical modulation and amplification chip are not limited in this application. In an example, the substrate and the waveguide layer are made of an InP material, and a thickness of the waveguide layer ranges from 1 µm to 2.5 µm. The lower separate confinement layer and the upper separate confinement layer are made of a quaternary material like unintentionally doped InGaAlAs, and thicknesses of the lower separate confinement layer and the upper separate confinement layer each range from 20 nm to 300 nm. The multiquantum well is made of a quaternary material like unintentionally doped InGaAlAs or InGaAsP, and a thickness of the multiquantum well ranges from 10 nm to 300 nm. A thickness of the electrical contact layer ranges from 50 nm to 300 nm.

In a possible implementation, at least one of the first region and the second region is provided with an optical filtering structure. In actual application, amplified spontaneous emission (Amplified Spontaneous Emission, ASE) light is generated when the optical modulation and amplification chip amplifies and modulates input light. Both the first region and the second region produce ASE light, which is not practically used and possesses a broad spectrum that makes it difficult absorb thereby hindering the achievement of a high extinction ratio of an optical pulse. Consequently, it is proposed to employ an optical filtering structure for bandpass filtering of the ASE light to eliminate out-of-band ASE light, thus enhancing the extinction ratio of the pulsed light. For instance, this could result in an extinction ratio exceeding 50 dB or 70 dB for the pulsed light post-filtering.

FIG. 5 is a diagram of a filtering spectrum of an optical filtering structure according to an embodiment of this application. As shown in FIG. 5, the abscissa indicates wavelength (unit: nm), and the ordinate indicates reflectivity. It can be learned that, a filtering range of the optical filtering structure is about 20 nm, effectively eliminating ASE light within a wavelength range of 1575 nm to 1595 nm. It should be understood that, the filtering spectrum shown in FIG. 5 is merely an example. In actual application, the filtering range of the optical filtering structure may be flexibly set. The following describes several specific implementations of the optical filtering structure.

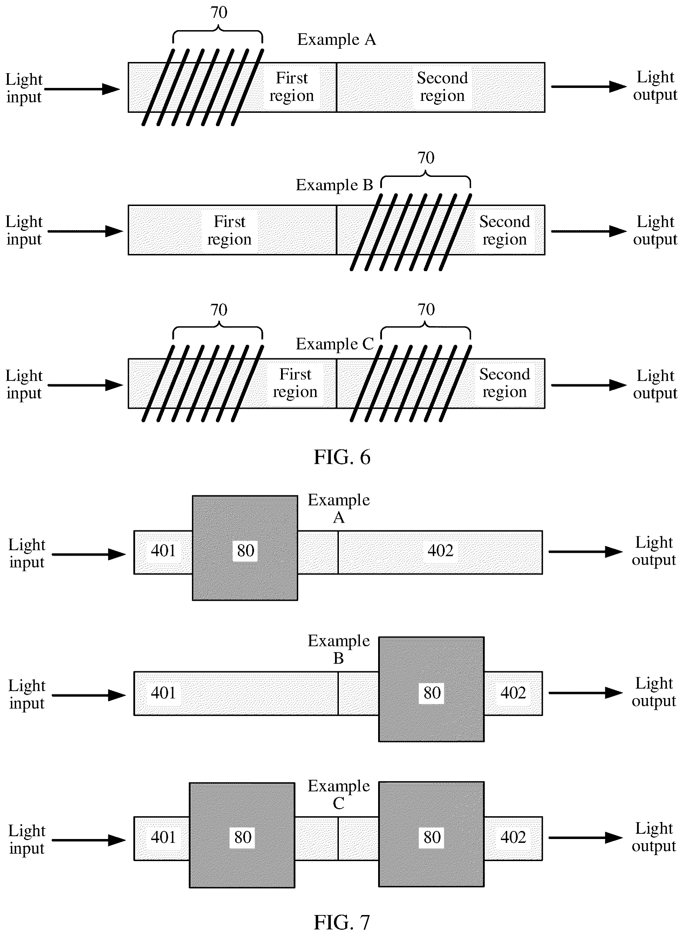

FIG. 6 is a diagram of a first implementation of an optical filtering structure according to an embodiment of this application. FIG. 6 shows a top view of the optical modulation and amplification chip. In this implementation, the optical filtering structure is a chirped grating 70. For example, in an example A of FIG. 6, the chirped grating 70 is located in the first region. For another example, in an example B of FIG. 6, the chirped grating 70 is located in the second region. For still another example, in an example C of FIG. 6, the chirped grating 70 is arranged in each of the first region and the second region. It should be understood that, a layer of the optical modulation and amplification chip at which the chirped grating 70 is arranged is not limited in this application. In FIG. 6, merely for ease of illustration, the chirped grating 70 is displayed at a top layer. For example, the chirped grating 70 may be arranged at the first epitaxial layer 601 shown in FIG. 1 or FIG. 2. For another example, the chirped grating 70 may alternatively be arranged at the active layer. For still another example, the chirped grating 70 may alternatively be arranged between the active layer and the waveguide layer.

It should be noted that, the chirped grating 70 may use a tilt design shown in FIG. 6. In other words, the chirped grating 70 is neither perpendicular nor parallel to a light transmission direction. In such a design manner, a resonant cavity may be prevented from being formed between reflected light and an end surface of the optical modulation and amplification chip, to avoid impact on an optical gain. In addition, in a filtering manner of the chirped grating, a size of the optical modulation and amplification chip is not additionally increased.

FIG. 7 is a diagram of a second implementation of an optical filtering structure according to an embodiment of this application. FIG. 7 shows a top view of the optical modulation and amplification chip. In this implementation, the optical filtering structure is a multimode interference (Multimode Interference, MMI) waveguide 80. It should be understood that, the MMI waveguide 80 is arranged at the waveguide layer of the optical modulation and amplification chip. For ease of illustration, FIG. 7 does not show the electrical contact layer located above the waveguide layer. For example, in an example A of FIG. 7, the MMI waveguide 80 is connected in series with the first waveguide 401. For example, in an example B of FIG. 7, the MMI waveguide 80 is connected in series with the second waveguide 402. For example, in an example C of FIG. 7, the MMI waveguide 80 connected in series with the first waveguide 401 is arranged in the first region, and the MMI waveguide 80 connected in series with the second waveguide 402 is arranged in the second region. It should be noted that, a width of the MMI waveguide 80 is generally greater than a width of the first waveguide 401 and a width of the second waveguide 402. Therefore, in a filtering manner of the MMI waveguide, only a wide waveguide needs to be etched, so that manufacturing is simple. However, a size of the optical modulation and amplification chip is also increased.

It should be noted that, in actual application, the optical modulation and amplification chip is not limited to being divided into two regions. More regions may be further added between the first region and the second region. No accompanying drawings are provided herein for presentation. For example, the optical modulation and amplification chip may further include a third region. The third region may be located between the first region and the second region, and the third region is electrically isolated from the first region and the second region. In the third region, light may be amplified, and may also be modulated. This is not specifically limited herein.

In embodiments of this application, electrical isolation between the first electrode 501 and the second electrode 502 may be implemented in a plurality of manners. The following separately describes the manners.

In a first manner, there are protons or inert ions injected between the first electrode 501 and the second electrode 502, to implement the electrical isolation between the first electrode 501 and the second electrode 502. The inert ions may be helium ions, neon ions, argon ions, or the like. It should be understood that, to make an overall structure of the optical modulation and amplification chip more compact and reduce interference, a distance between the first electrode 501 and the second electrode 502 should fall within a preset distance range.

In a second manner, as shown in FIG. 1 or FIG. 2, a groove is provided between the first electrode 501 and the second electrode 502. The groove may increase an isolation resistance between the first electrode 501 and the second electrode 502, to implement the electrical isolation between the first electrode 501 and the second electrode 502. It should be understood that, a depth of the groove is not limited in this application. Optionally, to improve an electrical isolation effect, protons or inert ions may be further injected into the groove.

It can be learned from the foregoing descriptions of the optical modulation and amplification chip that, the optical modulation and amplification chip includes a first region and a second region sharing a same substrate and that are electrically isolated. The first region is close to a light input end of the optical modulation and amplification chip, and the second region is close to a light output end of the optical modulation and amplification chip. Waveguides in the two regions are connected in series along a light transmission direction. Specifically, one region is for amplifying light, and the other region is for amplifying and modulating the light. An optical confinement factor of a first active layer of the first region is large, to facilitate implementation of a high gain. An optical confinement factor of a second active layer of the second region is small, and the second region has a high saturated output optical power, to facilitate implementation of a high output power. Therefore, the optical modulation and amplification chip provided in this application can meet requirements for the high gain amplification and the high output power.

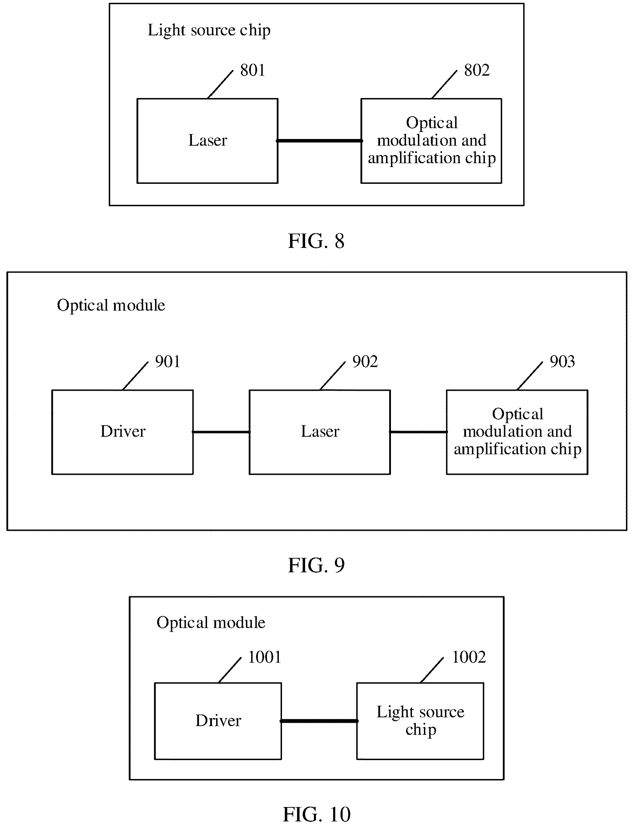

FIG. 8 is a diagram of a structure of a light source chip according to an embodiment of this application. As shown in FIG. 8, the light source chip includes a laser 801 and an optical modulation and amplification chip 802. The optical modulation and amplification chip 802 may be the optical modulation and amplification chip described in any one of the foregoing embodiments. Specifically, the laser 801 and the optical modulation and amplification chip 802 are integrated on a same substrate, and an external light source independent of the optical modulation and amplification chip does not need to be provided. The optical modulation and amplification chip 802 is configured to modulate and amplify light emitted by the laser 801. It should be understood that, a specific type of the laser 801 is not limited in this application. For example, the laser 801 may be a distributed feedback (Distributed Feedback, DFB) laser, or the laser 801 may be a tunable laser like a distributed Bragg (Distributed Bragg Reflector, DBR) laser.

FIG. 9 is a diagram of a structure of an optical module according to an embodiment of this application. As shown in FIG. 9, the optical module includes a driver 901, a laser 902, and an optical modulation and amplification chip 903. The optical modulation and amplification chip 903 may be the optical modulation and amplification chip described in any one of the foregoing embodiments. Specifically, the driver 901 is configured to drive the laser 902 to emit light, and drive the optical modulation and amplification chip 903 to modulate and amplify the light emitted by the laser 902.

FIG. 10 is a diagram of a structure of an optical module according to an embodiment of this application. As shown in FIG. 10, the optical module includes a driver 1001 and a light source chip 1002. The light source chip 1002 is the light source chip described in the embodiment shown in FIG. 8. Specifically, the driver 1001 is configured to drive a laser in the light source chip 1002 to emit light, and drive an optical modulation and amplification chip in the light source chip 1002 to modulate and amplify the light emitted by the laser.

Based on the foregoing descriptions of the optical modulation and amplification chip, the following describes an optical modulation and amplification method with reference to the optical modulation and amplification chip. It should be noted that, an apparatus structure corresponding to the optical modulation and amplification method may be as described in the foregoing apparatus embodiments. However, this is not limited to the optical modulation and amplification chip described above.

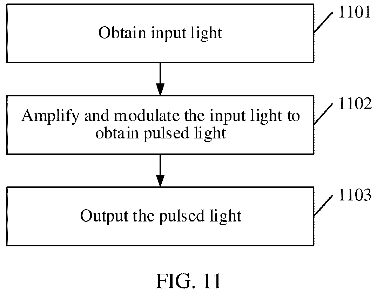

FIG. 11 is a diagram of an optical modulation and amplification method according to an embodiment of this application. In this example, the optical modulation and amplification method includes the following steps.

1101: Obtain input light.

Specifically, the input light may be light input to an optical modulation and amplification chip. For a specific structure of the optical modulation and amplification chip, refer to the related descriptions of the foregoing apparatus embodiments. Details are not described herein again.

1102: Amplify and modulate the input light to obtain pulsed light.

In a possible implementation, refer to FIG. 1. Light transmitted in a first waveguide is amplified, and the light transmitted in a second waveguide is amplified and modulated to obtain the pulsed light. Specifically, a direct current is loaded by using a first electrode to amplify the light transmitted in the first waveguide, and a modulation signal is loaded by using a second electrode to amplify and modulate the light transmitted in the second waveguide to obtain the pulsed light.

In another possible implementation, refer to FIG. 2. Light transmitted in a first waveguide is amplified and modulated to obtain the pulsed light, and the pulsed light transmitted in a second waveguide is amplified. Specifically, a modulation signal is loaded by using a first electrode to amplify and modulate the light transmitted in the first waveguide to obtain the pulsed light, and a direct current is loaded by using a second electrode to amplify the pulsed light transmitted in the second waveguide.

1103: Output the pulsed light.

It should be understood that, modulating light in a region where a modulation signal is applied simultaneously achieves optical amplification. Specifically, for modulated pulsed light, this region absorbs pulses with an amplitude of 0 and amplifies those with an amplitude of 1. It is equivalent to that this effectively weakens pulses at amplitude 0 while strengthening those at amplitude 1, thereby increasing an extinction ratio of the pulsed light. For instance, it can achieve an extinction ratio exceeding 40 dB.

It should be noted that, in some possible scenarios, bandpass filtering may be further performed on ASE light generated through amplification and modulation in the optical modulation and amplification chip, to filter out the ASE light, thereby further increasing the extinction ratio of the pulsed light. For example, an extinction ratio of pulsed light post-bandpass filtering exceeds 50 dB or 70 dB.

Finally, it should be noted that the foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An optical modulation and amplification chip, comprising a first region and a second region sharing a same substrate, wherein the first region and the second region are electrically isolated, the first region is close to a light input end of the optical modulation and amplification chip, the second region is close to a light output end of the optical modulation and amplification chip, a first waveguide of the first region and a second waveguide of the second region are connected in series along a light transmission direction of the optical modulation and amplification chip, and an optical confinement factor of a first active layer of the first region is greater than an optical confinement factor of a second active layer of the second region; and
the first region is for amplifying light transmitted in the first waveguide, and the second region is for amplifying and modulating the light transmitted in the second waveguide to obtain pulsed light; or the first region is for amplifying and modulating light transmitted in the first waveguide to obtain pulsed light, and the second region is for amplifying the pulsed light transmitted in the second waveguide.

2. The optical modulation and amplification chip according to claim 1, wherein the first region and the second region share a same active layer, the first waveguide comprises a first epitaxial layer, the second waveguide comprises a second epitaxial layer, and a refractive index of the first epitaxial layer is greater than a refractive index of the second epitaxial layer.

3. The optical modulation and amplification chip according to claim 1 or 2, wherein a first passive waveguide layer of the first region and a second passive waveguide layer of the second region are located on the substrate, the first active layer is located on the first passive waveguide layer, and the second active layer is located on the second passive waveguide layer; and
a thickness of the first passive waveguide layer is less than a thickness of the second passive waveguide layer, and/or a refractive index of the first passive waveguide layer is less than a refractive index of the second passive waveguide layer, and/or a distance between the first passive waveguide layer and the first active layer is less than a distance between the second passive waveguide layer and the second active layer.

4. The optical modulation and amplification chip according to any one of claims 1 to 3, wherein the first region and/or the second region comprises an optical filtering structure, and the optical filtering structure is configured to perform bandpass filtering on amplified spontaneous emission ASE light generated through amplification and modulation in the optical modulation and amplification chip.

5. The optical modulation and amplification chip according to claim 4, wherein the optical filtering structure is a chirped grating, and an included angle between the chirped grating and the light transmission direction of the optical modulation and amplification chip is greater than 0° and less than 90°.

6. The optical modulation and amplification chip according to claim 4, wherein the optical filtering structure is a multimode interference MMI waveguide, and the MMI waveguide is connected in series with the first waveguide or the second waveguide.

7. The optical modulation and amplification chip according to any one of claims 1 to 6, wherein a first electrode of the first region is configured to load a direct current, and a second electrode of the second region is configured to load a modulation signal; or a first electrode of the first region is configured to load a modulation signal, and a second electrode of the second region is configured to load a direct current.

8. The optical modulation and amplification chip according to any one of claims 1 to 7, wherein the first waveguide uses a ridge waveguide structure or a buried heterojunction BH structure, and the second waveguide uses a ridge waveguide structure or a BH structure.

9. The optical modulation and amplification chip according to any one of claims 1 to 8, wherein a groove is provided for electrical isolation between the first electrode of the first region and the second electrode of the second region.

10. The optical modulation and amplification chip according to claim 9, wherein there are protons or inert ions injected into the groove.

11. The optical modulation and amplification chip according to any one of claims 1 to 8, wherein there are protons or inert ions injected between the first electrode of the first region and the second electrode of the second region.

12. A light source chip, comprising a laser and the optical modulation and amplification chip according to any one of claims 1 to 11, wherein the laser and the optical modulation and amplification chip are integrated on a same substrate, and the optical modulation and amplification chip is configured to modulate and amplify light emitted by the laser.

13. An optical module, comprising a laser, a driver, and the optical modulation and amplification chip according to any one of claims 1 to 11, wherein the driver is configured to drive the laser to emit light, and drive the optical modulation and amplification chip to modulate and amplify the light emitted by the laser.

14. An optical module, comprising a driver and the light source chip according to claim 12, wherein the driver is configured to drive a laser in the light source chip to emit light, and drive an optical modulation and amplification chip in the light source chip to modulate and amplify the light emitted by the laser.

15. An optical modulation and amplification method, comprising:
obtaining input light of an optical modulation and amplification chip, wherein the optical modulation and amplification chip comprises a first region and a second region, the first region and the second region are electrically isolated, the first region is close to a light input end of the optical modulation and amplification chip, the second region is close to a light output end of the optical modulation and amplification chip, the input light is transmitted in a first waveguide of the first region and a second waveguide of the second region, and an optical confinement factor of a first active layer of the first region is greater than an optical confinement factor of a second active layer of the second region;
amplifying the light transmitted in the first waveguide, and amplifying and modulating the light transmitted in the second waveguide to obtain pulsed light; or amplifying and modulating the light transmitted in the first waveguide to obtain pulsed light, and amplifying the pulsed light transmitted in the second waveguide; and
outputting the pulsed light, wherein an extinction ratio of the pulsed light exceeds 40 dB.

16. The method according to claim 15, wherein the method further comprises:
performing bandpass filtering on amplified spontaneous emission ASE light generated through amplification and modulation in the optical modulation and amplification chip, wherein an extinction ratio of pulsed light post-bandpass filtering exceeds 50 dB.

17. The method according to claim 15 or 16, wherein amplifying the light transmitted in the first waveguide, and amplifying and modulating the light transmitted in the second waveguide to obtain the pulsed light comprises:
loading a direct current by using a first electrode of the first region to amplify the light transmitted in the first waveguide, and loading a modulation signal by using a second electrode of the second region to amplify and modulate the light transmitted in the second waveguide to obtain the pulsed light; or
amplifying and modulating the light transmitted in the first waveguide to obtain the pulsed light, and amplifying the pulsed light transmitted in the second waveguide comprises:
loading a modulation signal by using a first electrode of the first region to amplify and modulate the light transmitted in the first waveguide to obtain the pulsed light, and loading a direct current by using a second electrode of the second region to amplify the pulsed light transmitted in the second waveguide.
